# EUROPEAN PATENT APPLICATION

(11) **EP 3 882 038 A1**
(43) Date of publication of application: **22.09.2021**
(21) Application number: 20163835.0
(22) Date of filing: 18.03.2020
(51) Int. Cl.: B41J 3/407, H01L 23/552, B41J 11/00, H01L 21/677

(54) **ASSEMBLY FOR AN INKJET PRINTER, INKJET PRINTER AND METHOD FOR PRINTING A FUNCTIONAL LAYER ON A SURFACE OF A THREE-DIMENSIONAL ELECTRONIC DEVICE**

(71) Applicant: Heraeus Deutschland GmbH & Co. KG, 63450 Hanau (DE)
(72) Inventor: Stadnik, Alan Paul, 63450 Hanau (DE); Steigerwald, Andreas, 63450 Hanau (DE)
(74) Representative: Glas, Holger

(57) **Abstract**

The present invention relates to an assembly configured for moving a three-dimensional electronic device 1000 in an inkjet printer 1. The assembly comprises (i) a first fixture 3a configured to hold a first print head 200; and (ii) at least two processing lines A, B, C, D, wherein each processing line A, B, C, D includes a first printing section 20 in which a functional layer is printed on a surface of the electronic device 1000, a curing section 40 configured to cure the functional layer on the surface of the electronic device 1000, and a transport mechanism 4 configured to move from the printing section 20 to the curing section 40. The first fixture 3a is movable from one of the at least two processing lines A, B, C, D to the other of the at least two processing lines A, B, C, D. The present invention also relates to an inkjet printer 1 and a method for printing a functional layer on a surface of an electronic device 1000.

## Description

The present invention relates to an assembly configured for moving a three-dimensional electronic device in an inkjet printer. The present invention also relates to an inkjet printer including the afore-mentioned assembly and a method for printing a functional layer on a surface of first and second three-dimensional electronic devices in an inkjet printer.

Inket printers have been widely used for printing on paper. However, inkjet printers may also be used for other purposes. For example, inkjet printers may be employed for depositing conductive ink on electronic devices, such as for example on a "System in Package" (SIP) to protect the same from electromagnetic interference.

SIP modules play an increasingly important role in the miniaturization of portable electronic devices. Due to the high density of the electrical functions built into an SIP module, electromagnetic or electrical interference (EMI) may cause complete failure of the module. To this end, SIP modules have to be shielded to both inhibit EMI radiation to emanate from and to be received by the SIP module.

Traditionally, SIP modules use a metal housing for the purpose of EMI shielding. A metal housing, however, counterfeits the objective of miniaturization. Instead of using a metal housing, a functional layer consisting, for example, of a silver containing inkjet ink can be deposited on the surface of a SIP module using an inkjet printer. Once the inkjet ink is printed on the surface of the SIP module, the inkjet ink is cured using, for example, UV light in order to form a continuous functional layer on the surface of the SIP module. Other means for curing are conceivable, such as IR-radiation or plasma.

US 2013/0342592 A1 discloses an inkjet printer which is used for printing an EMI shield on a three-dimensional electronic device. The electronic device is thereby mounted on a fixture that can be tilted and rotated so that the EMI shield can be deposited uniformly on non-parallel surfaces of the electronic device.

An object of the present invention is to provide an inkjet printer, and an assembly for an inkjet printer, as well as a method for printing a functional layer on a surface of an electronic device with increased efficiency, and in particular with high throughput.

This object is solved by the subject-matter of independent claims 1, 14 and 16. Optional and preferred features of the present invention are subject of dependent claims 2 to 13 and 15.

According to a first aspect of the present invention, an assembly is provided which is configured for moving a three-dimensional electronic device in an inkjet printer. The assembly comprises a first fixture configured to hold a first print head, and at least two processing lines. Each processing line includes a first printing section in which a functional layer is printed on a surface of the electronic device, a curing section configured to cure the functional layer on the surface of the electronic device, and a transport mechanism configured to move from the printing section to the curing section. The first fixture is configured to be movable from one of the at least two processing lines to the other of the at least two processing lines.

Preferably, the printing section and the curing section of each processing line are co-linearly arranged.

More preferably, the at least two processing lines are parallel to one another.

According to a preferred embodiment of the invention, the assembly further comprises a support configured to hold the electronic device, wherein the first fixture and the support are configured such that they are movable relative to each other.

It is advantageous if the support is fixedly mounted to the transport mechanism, and the first fixture is movable relative to the support.

Optionally, the transport mechanism is configured to reciprocate between the printing section and the curing section.

It is also a preferred feature of the invention if the transport mechanism is a sliding carriage or a belt-conveyor.

According to another preferred embodiment of the invention, the assembly further comprises a pre-treatment section which includes a device selected from the group consisting of a hard UV emitter, an excimer laser or an atmospheric plasma-generating device.

Preferably, at least one of the at least two processing lines includes the pre-treatment section upstream of the printing section.

More preferably, the curing section includes an UV-light emitter or an IR-radiation emitter.

Yet more preferably, the assembly further comprises a second fixture configured to hold a second print head.

It is also preferred if the second fixture is arranged within a protection layer printing section downstream of the curing section, wherein the transport mechanism is configured to move from the printing, to the protection layer printing section and to the curing section.

Optionally, the second fixture is configured to be movable from one of the at least two processing lines to the other of the at least two processing lines.

According to a second aspect of the present invention, an inkjet printer is provided which is configured for printing a functional layer on a surface of an electronic device. The inkjet printer comprises a print head configured to eject an ink, and an assembly as described above.

Preferably, the print head is configured to eject an ink which, after being printed on the surface of the electronic device and after curing, forms an electromagnetic interference shielding on the electronic device.

According to a third aspect of the present invention, a method is provided for printing a functional layer on a surface of first and second three-dimensional electronic devices in an inkjet printer having a print head and at least first and second processing lines each including a printing section and a curing section. The method comprises the steps of arranging the print head within the printing section of the first processing line, printing a functional layer on a surface of the first electronic device within the printing section of the first processing line, moving the first electronic device to the curing section of the first processing line, curing the functional layer of the first electronic device within the curing section of the first processing line, moving the print head to the printing section of the second processing line, printing a functional layer on a surface of the second electronic device within the printing section of the second processing line whilst the functional layer of the first electronic device is cured within the curing section of the first processing line.

The present invention will now be described by way of example using the attached drawings. The drawings are for illustrative purposes and serve only to provide an example of a possible assembly configured for moving a three-dimensional electronic device in an inkjet printer, of a possible inkjet printer and a possible method for inkjet printing on a surface of a three-dimensional electronic device. The drawings in no way limit the present invention, but merely represent a preferred embodiment thereof.

The present invention is generally suitable for high-volume printing inkjet ink on three-dimensional devices, such as for example electronic devices. It is particularly suitable to deposit a functional layer on a so-called "System in Package" (SIP). The functional layer may be any sort of layer which, when being applied, achieves a particular function. This function may be the shielding of the electronic device from electromagnetic interference (EMI) caused by electromagnetic induction or electromagnetic radiation emitted from an external source. The functional layer may be composed of a conductive ink which is a type of ink that is conductive, such as silver ink or silver containing ink. The conductive ink may also be of a type which includes conductive particles, for example silver particles. In order for the conductive ink to act as an EMI shield, printing must be performed such that the conductive ink forms a continuous layer, preferably with uniform thickness, on the electronic device with no gaps larger than a quarter wavelength of the frequency of the external electromagnetic radiation which is to be blocked.

The electronic devices may have any three-dimensional geometry with surfaces extending in different directions. To this end, the print head used in the present invention may be pivotal around different axes of rotation such that non-parallel surfaces of the electronic device may be EMI shielded with a continuous functional layer.

The present invention is not limited to printing conductive ink on three-dimensional electronic devices, but can in principle be employed in any inkjet printing process which requires a high throughput.

The printing width of the print head used in the present invention may be selected depending on the size of the electronic device, for example 12 inch and larger. The printing speed may be up to 2000 mm/second, whereas the print head frequency which is the frequency at which ink droplets are ejected by the print head, may be up to 150 kHz.

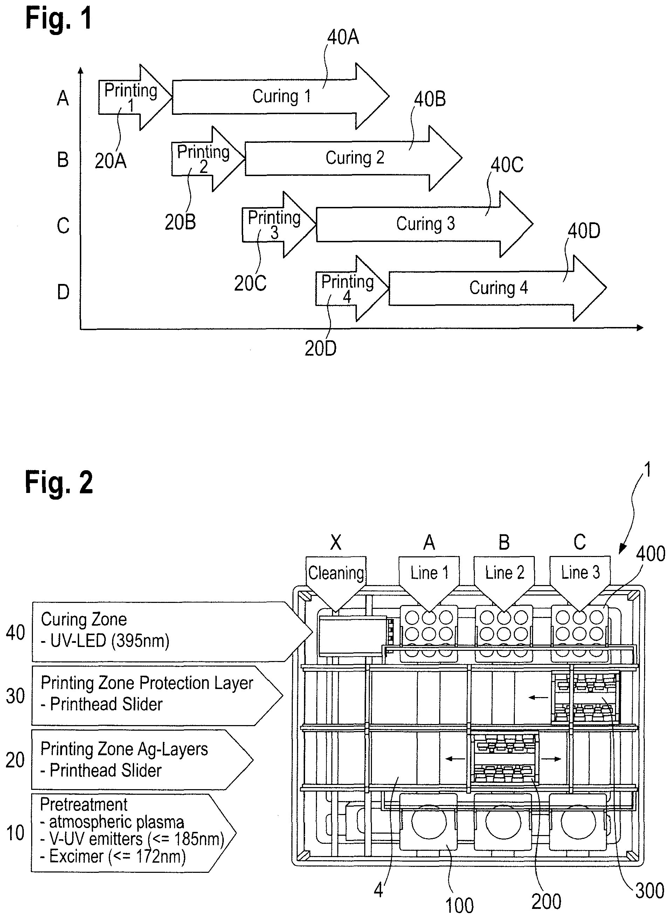

Fig. 1 illustrates the general principles of the invention. According to Fig. 1, at least two, for example four processing lines A-D are provided. Each processing line A-D includes a printing section 20A-20D and a curing section 40A-40D.

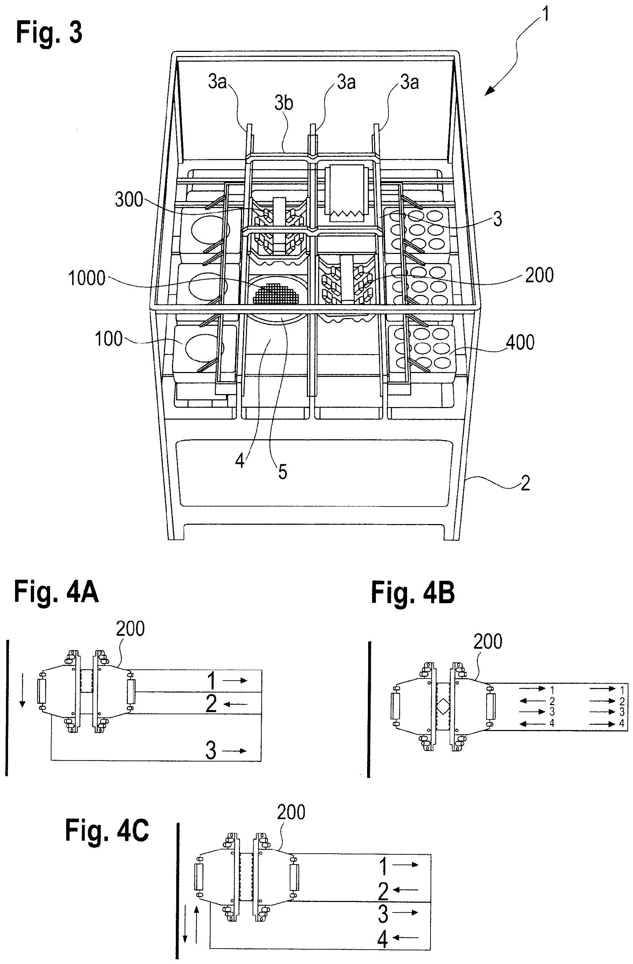

A functional layer is first deposited on the surface (or surfaces) of a first three-dimensional electronic device 1000 (Fig. 3) within the printing section 20A. In order to generate a continuous functional layer on the surface of the first electronic device 1000, either the print head 200 (Fig. 2) is moved relative to the first electronic device 1000, or the first electronic device 1000 is moved relative to the print head 200. Once the functional layer has been printed on the first electronic device 1000, the first electronic device 1000 is moved from the printing section 20A to the curing section 40A of the first processing line A. The functional layer is cured within the curing section 40A, and during curing, the print head 200 is moved to the printing section 20B of the second processing line B. A second electronic device 1000 is printed within the printing section 20B of the second processing line B, and once the printing is completed, the second electronic device 1000 is moved along the second processing line B to the curing section 40B. Whilst the first and second electronic devices 1000 in processing lines A and B are cured in curing sections 40A, 40B, respectively, a functional layer is printed on a third electronic device 1000 within the printing section 20C of the third processing line C. Upon completion of the printing of the third electronic device 1000 within the printing section 20C, the third electronic device 1000 is moved to the curing section 40C of the third processing line C. Whilst curing is still ongoing in curing sections 40A, 40B, 40C, the print head 200 is moved to the printing section 20D of the fourth processing line D. Here, printing of a fourth electronic device 1000 is carried out. Once completed, the fourth electronic device 1000 is moved to the curing section 40D of the fourth processing line D.

Using the principles of the present invention, an inkjet printing process with high throughput can be achieved. Because the duration of the printing process is only a fraction of the duration of the curing process, the time period during which curing takes place can be utilized for printing another electronic device in another processing line. In other words, printing of a second electronic device can start immediately upon completion of the printing of a first electronic device.

Fig. 2 is a top view and shows the general structure of an inkjet printer 1 having three processing lines A, B, C. In contrast to the general principle shown in Fig. 1, a cleaning section X may be provided in which the surfaces of the electronic device 1000 are cleaned prior to printing. Preferably, a pre-treatment section 10 is provided in which the surface or surfaces of the electronic device 1000 to be printed are activated by oxidation. The activation can be achieved by using an atmospheric plasma or hard UV radiation using an UV emitter having an emission wavelength of smaller than 185 nm or an Excimer laser having an emission wavelength of smaller than 172 nm.

Once the surface(s) of the electronic device 1000 is preferably cleaned and pre-treated, the electronic device 1000 is moved to the printing section 20, and after the printing process, transported to the curing section 40. Curing is preferably achieved by using an UV-LED 400 emitting UV radiation at a wavelength of 395 nm. Alternatively, an IR-radiation emitter may be used for the purpose of curing. As can be seen in Fig. 2, the print head 200 can be moved from one processing line A to any of the other processing lines B and C. It may also reciprocate between the processing lines A, B and C.

Preferably, an additional printing section 30 may be provided in which a print head 300 is installed in order to print a protection layer on top of the functional layer printed previously within printing section 20. As with the print head 200, either the print head 300 is moved relative to the electronic device 1000, or the electronic device 1000 is moved relative to the print head 300.

To move the electronic device 1000 from either printing section 20 or 30 to the curing section 40, a transport mechanism 4, preferably in the form of a sliding carriage or a belt-conveyor, is provided.

Fig. 3 is a perspective view of a stand-alone inkjet printer 1 according to a preferred embodiment of the invention. The inkjet printer 1 includes a rigid frame 20, to which is attached a number of guiding rails 3a, 3b arranged in a grid-like pattern. The print head 200 is movably attached to the frame 2, so that it can move along the rails 3a from one processing line A to any of the other processing lines B, C or D. The same applies to the print head 300 provided in the protection layer printing section 30. Below the print heads 200, 300 and below the UV-LED 400 in the curing section 40 and the hard UV emitter 100 in the pre-treatment section 10 is located the electronic device 1000 which is held in place by using a support 5. The support 5 may be any sort of support configured to hold one or a multiplicity of electronic devices 1000. As mentioned above, the support 5 may be pivotal around one or more different axes of rotation.

The printing process may be a multi-path or a single-path or a combination thereof, as shown in Fig. 4A to 4C.

In the multi-path process shown in Fig. 4A, a series of relative movements of the print head 200 and the electronic device 1000 within the printing section 20 of one processing line A, B, or C is utilized so that multiple layers of conductive ink are deposited thereon. Preferably, the print head 200 is stationary, whereas the electronic device 1000 is reciprocated in one direction, for example in X-direction, below the print head 200. Furthermore, movement of the electronic device 1000 in X-direction may preferably be overlapped by a movement of the print head 200 in Y-direction (i.e. orthogonal to the X-direction), so that multiple, in Y-direction overlapping layers of the conductive ink are printed on the electronic device 1000. The overlap of the multiple layers of the conductive ink may be controlled by the amount of movement of the print head 200 in Y-direction. As a result, the conductive ink may have a varying thickness in Y-direction, such as for example with a step-like or continuous profile. After each layer, the electronic device 1000 may preferably be moved to the curing section 40 to effect curing of the conductive ink layer. Alternatively, curing is effected once the multiple layers of the conductive ink have been printed on the electronic device 1000. The foregoing printing and curing processes may be repeated, if desired.Optionally, a protection layer is printed within the printing section 30 on top of the uppermost conductive ink layer which then has to be cured within the curing section 40.

In the single-path process shown in Fig. 4B, the print head 200 is stationary in both X-direction and Y-direction. Only the electronic device 1000 is reciprocated in X-direction below the print head 200 until a desired thickness of the conductive ink has been printed on the electronic device 1000. It is preferred that printing (coating) of the electronic device 1000 takes place only during movement of the electronic device 1000 in one direction, but not in the opposite direction. Alternatively, the electronic device 1000 may preferably be printed continuously during movement in both directions. After printing, the electronic device 1000 may preferably be moved to the curing section 40 to effect curing of the single or multiple conductive ink layers. The foregoing printing and curing processes may be repeated, if desired.

Fig. 4C shows a combination of the multi-path process of Fig. 4A and the single-path process of Fig. 4B. The only difference being that the multiple layers of the conductive ink printed on the electronic device 1000 do not overlap in Y-direction.

## Claims

1. An assembly configured for moving a three-dimensional electronic device (1000) in an inkjet printer (1), the assembly comprising:
a first fixture (3a) configured to hold a first print head (200); and
at least two processing lines (A, B, C, D), each processing line (A, B, C, D) including:
a first printing section (20) in which a functional layer is printed on a surface of the electronic device (1000),
a curing section (40) configured to cure the functional layer on the surface of the electronic device (1000), and
a transport mechanism (4) configured to move from the printing section (20) to the curing section (40);
wherein the first fixture (3a) is configured to be movable from one of the at least two processing lines (A, B, C, D) to the other of the at least two processing lines (A, B, C, D).

2. The assembly of claim 1, wherein the printing section (20) and the curing section (40) of each processing line (A, B, C, D) are co-linearly arranged.

3. The assembly of claim 1 or 2, wherein the at least two processing lines (A, B, C, D) are parallel to one another.

4. The assembly of any of the preceding claims, further comprising a support (5) configured to hold the electronic device (1000), wherein the first fixture (3a) and the support (5) are configured such that they are movable relative to each other.

5. The assembly of claim 4, wherein the support (5) is fixedly mounted to the transport mechanism (4), and the first fixture (3a) is movable relative to the support (5).

6. The assembly of any of the preceding claims, wherein the transport mechanism (4) is configured to reciprocate between the printing section (20) and the curing section (40).

7. The assembly of any of the preceding claims, wherein the transport mechanism (4) is a sliding carriage or a belt-conveyor.

8. The assembly of any of the preceding claims, further comprising a pre-treatment section (10) which includes a device (100) selected from the group consisting of a hard UV emitter, an excimer laser or an atmospheric plasma-generating device.

9. The assembly of claim 8, wherein at least one of the at least two processing lines (A, B, C, D) includes the pre-treatment section (10) upstream of the printing section (20).

10. The assembly of any of the preceding claims, wherein the curing section (40) includes an UV-light emitter or an IR-radiation emitter (400).

11. The assembly of any of the preceding claims, further comprising a second fixture (3a) being configured to hold a second print head (300).

12. The assembly of claim 11, wherein the second fixture (3a) is arranged within a protection layer printing section (30) downstream of the curing section (40), and wherein the transport mechanism (4) is configured to move from the printing (20), to the protection layer printing section (30) and to the curing section (40).

13. The assembly of claim 11 or 12, wherein the second fixture (3a) is configured to be movable from one of the at least two processing lines (A, B, C, D) to the other of the at least two processing lines (A, B, C, D).

14. An inkjet printer (1) configured for printing a functional layer on a surface of an electronic device (1000), comprising
a print head (200) configured to eject an ink; and
an assembly of any of the preceding claims.

15. The inkjet printer (1) of claim 14, wherein the print head (200) is configured to eject an ink which, after being printed on the surface of the electronic device (1000) and after curing, forms an electromagnetic interference shielding on the electronic device (1000).

16. A method for printing a functional layer on a surface of first and second three-dimensional electronic devices (1000) in an inkjet printer (1) having a print head (200) and at least first and second processing lines (A, B, C, D), each processing line (A, B, C, D) including a printing section (20) and a curing section (40), the method comprising the steps of:
arranging the print head (200) within the printing section (20A) of the first processing line (A);
printing a functional layer on a surface of the first electronic device (1000) within the printing section (20A) of the first processing line (A);
moving the first electronic device (1000) to the curing section (40A) of the first processing line (A);
curing the functional layer of the first electronic device (1000) within the curing section (40A) of the first processing line (A);
moving the print head (200) to the printing section (20B) of the second processing line (B);
printing a functional layer on a surface of the second electronic device (1000) within the printing section (20B) of the second processing line (B) whilst the functional layer of the first electronic device (1000) is cured within the curing section (40A) of the first processing line (A).
